Europäisches Patentamt

European Patent Office

Office européen des brevets

(19)

(11) Numéro de publication: **0 192 530**
**B1**

## (12) FASCICULE DE BREVET EUROPEEN

(45) Date de publication du fascicule du brevet:
**28.12.88**

(51) Int. Cl.⁴: **G 01 R 29/02,** G 01 P 3/489

(21) Numéro de dépôt: **86400194.6**

(22) Date de dépôt: **30.01.86**

(54) **Dispositif pour comparer les durées de deux créneaux.**

(30) Priorité: **05.02.85 FR 8501862**

(43) Date de publication de la demande:
**27.08.86 Bulletin 86/35**

(45) Mention de la délivrance du brevet:
**28.12.88 Bulletin 88/52**

(84) Etats contractants désignés:
**DE GB IT**

(56) Documents cités:
**FR-A- 2 262 793**

**PATENTS ABSTRACTS OF JAPAN, vol. 7, no. 82 (P-189)
[1227], 6 avril 1983
PATENTS ABSTRACTS OF JAPAN, vol. 7, no. 168 (P-212)
[1313], 23 juillet 1983
ELECTRONICS INTERNATIONAL, vol. 53, no. 26,
décembre 1980, page 162, New York, US; P. GALUZZI:
"Pulse-width meter displays values digitally"**

(73) Titulaire: **AUTOMOBILES PEUGEOT, 75, avenue de la
Grande Armée, F-75116 Paris (FR)**
Titulaire: **AUTOMOBILES CITROEN, 62 Boulevard
Victor-Hugo, F-92200 Neuilly-sur-Seine (FR)**

(72) Inventeur: **Herbault, Patrick Jean-Pierre, 94, rue Thiers,
F-92100 Boulogne S/Seine (FR)**

(74) Mandataire: **Boivin, Claude, 9, rue Edouard-Charton,
F-78000 Versailles (FR)**

## Description

Il est connu de comparer la durée de deux créneaux successifs produits par la rotation d'une pièce tournante, par exemple à l'aide d'une denture associée à cette pièce, pour mesurer l'accélération ou la décélération angulaire de ladite pièce.

Les dispositifs utilisés jusqu'à présent à cet effet comportent des moyens pour diviser la durée d'un créneau par un nombre $N_0$ donné et pour diviser la durée du créneau suivant par le quotient de la première division. Le rapport du nombre N obtenu au nombre $N_0$ est le même que celui des durées de deux créneaux. Mais ces dispositifs sont imparfaits car si les durées des deux créneaux sont relativement voisines, la valeur de N devrait être égale à $N_0$, ce qui n'est en général pas le cas avec les dispositifs actuellement réalisés (voir le document FR-A-2 262 793).

La présente invention a pour objet un dispositif pour comparer les durées de deux créneaux qui remédie à cet inconvénient.

Le dispositif selon l'invention comprend des moyens pour diviser la durée d'un créneau par un nombre $N_0$ donné, des moyens pour mettre en mémoire le quotient da la division, et des moyens pour diviser la durée du créneau suivant par ce quotient, et est caractérisé en ce qu'il comporte en outre des moyens pour mettre en mémoire le reste de la division de la durée d'un créneau par le nombre $N_0$, et des moyens pour supprimer de la durée du créneau suivant une fraction de cette durée proportionnelle au reste ainsi mis en mémoire, la durée obtenue par la suppression étant utilisée comme dividende par lesdits moyens pour diviser la durée du créneau suivant.

Les moyens pour supprimer de la durée du créneau suivant une fraction de cette durée comprennent de préférence un multiplicateur binaire synchrone à $\underline{N}$ bits connu dans la technique sous le nom de «Binary Rate Multiplier» qui fournit des impulsions à une fréquence de sortie égale à la fréquence d'entrée multipliée par $M/2^n$, M étant un nombre préalablement mis en mémoire dans le multiplicateur.

On a décrit ci-après, à titre d'exemple non limitatif, un mode de réalisation du dispositif selon l'invention avec référence au dessin annexé dans lequel:

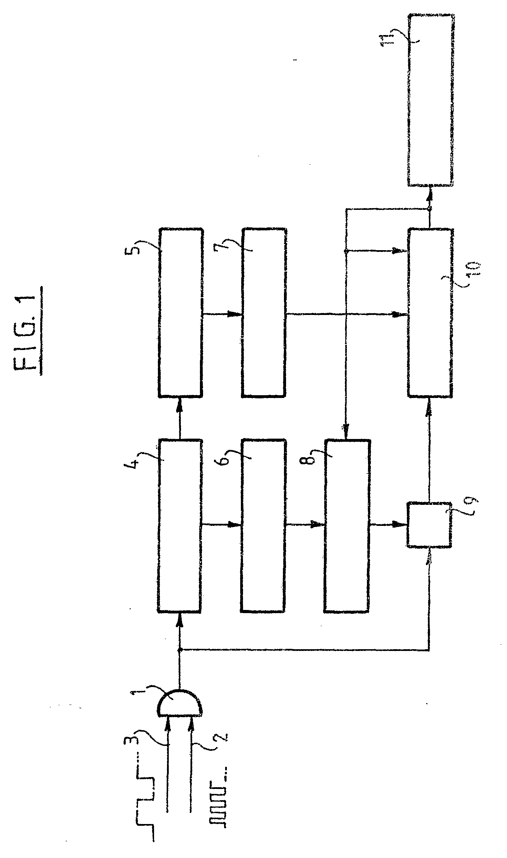

La Figure 1 est un schéma du dispositif;

La Figure 2 est le schéma d'un mode de réalisation pratique.

Tel qu'il est représenté au dessin, le dispositif comprend une porte ET 1 qui est connectée à une horloge par une liaison 2 et une liaison 3 fournissant un signal constitué par des créneaux dont la durée est variable.

La sortie de la porte ET 1 est connectée à un diviseur 4 propre à diviser par un nombre donné $N_0$ le nombre d'impulsions qui lui est transmis. Ce diviseur est connecté d'une part à un compteur 5 qui compte le résultat de la division et à une mémoire 6 dans laquelle le reste de la division est mis en mémoire. Le compteur 5 est connecté à une mémoire 7 qui stocke le contenu du compteur 5.

La sortie de la mémoire est connectée à un multiplicateur de fréquence 8, du type B.R.M. (Binary Rate Multiplier) par exemple celui vendu dans le commerce par la Société Texas Instruments sous la dénomination SN 5497, dont la sortie est connectée à l'une des entrées d'une porte ET 9 ayant son autre entrée connectée à la sortie de la porte 1.

Un compteur préchargeable 10 monté en diviseur programmable est connecté à la sortie de la porte 9 et à la mémoire de façon à diviser le nombre d'impulsions qu'il reçoit par le contenu de la mémoire 7. La sortie du diviseur 10 est connectée à un compteur 11.

Le rapport du nombre N indiqué par le compteur au nombre $N_0$ est proportionnel au rapport des durées de deux créneaux consécutifs. En particulier, si les deux créneaux ont des durées égales, le nombre N est égal à $N_0$. Si, par exemple, le nombre $N_0$ est égal à 64 et si la porte 1 laisse passer 700 impulsions pendant la durée du créneau, le quotient à savoir 10 sera stocké dans la mémoire 7, alors que le reste soit 60 sera stocké dans la mémoire 6. Pendant la durée du créneau suivant en l'absence du dispositif 8, le compteur 10 préchargé à 10 fournirait pendant les 700 impulsions 70 impulsions au compteur 11. Le dispositif 8 laisse passer 60/64 des impulsions sortant du compteur 10; 60 est le reste mémorisé dans la mémoire 6.

Pendant les 64 premières impulsions du compteur 10, le B.R.M. supprime donc $\dfrac{60 \times 64}{64}$ soit 60 impulsions par la porte 9 sur les 700 impulsions entrant dans le compteur 10 soit 640 restantes.

L'ensemble des impulsions P conduit à 60 suppressions d'impulsions par le dispositif 8, à 64 rechargements du compteur 10 préchargé en diviseur par 10, et donc à un comptage par le compteur 11 de 64 impulsions soit $N_0$.

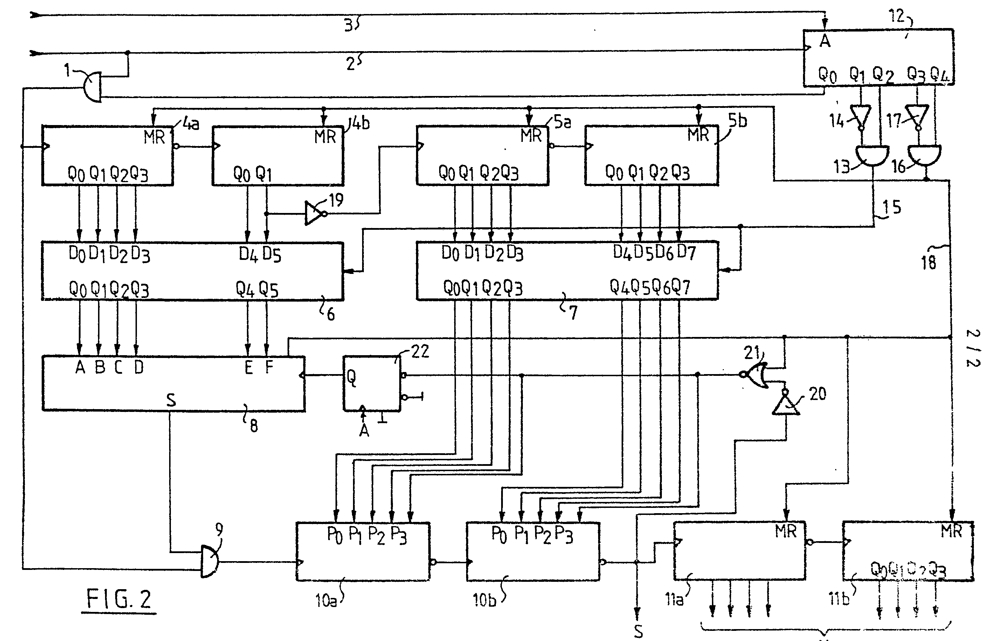

Dans le mode de réalisation représenté à la Figure 2, la liaison 2 fournissant le signal d'horloge est connectée à l'entrée horloge d'un registre à décalage 12; le signal fourni par la liaison 3 est envoyé à l'entrée «données» de ce circuit. La sortie $Q_0$ du registre 12 est reliée à la porte 1, ainsi que le circuit 2; cette porte délivre ainsi des impulsions en nombre P pendant la durée d'un créneau. La sortie $Q_2$ du registre est connectée à une porte ET 13, ainsi que sa sortie $Q_1$ par l'intermédiaire d'une porte inverseuse 14; la sortie de cette porte 13 envoie dans la liaison 15 un signal de contrôle constitué par une impulsion d'horloge décalée d'un cycle d'horloge après le front de descente du créneau transmis en $Q_0$. De même, la sortie $Q_4$ du registre est connectée à une porte ET 16, ainsi que sa sortie $Q_3$ par l'intermédiaire d'une porte inverseuse 17; la sortie de cette porte envoie dans la liaison 18 un signal de contrôle constitué par une impulsion d'horloge décalée de trois cycles d'horloge après le front de descente du créneau transmis par $Q_0$.

Le diviseur par $N_0$ ($64 = 2^6$) est constitué par deux compteurs 4a et 4b montés en cascade dont on utilise les six bits de poids faible. L'entrée de «remise à zéro» de ces compteurs est connectée à la porte 16. La sortie $Q_1$ du compteur 4b qui repasse à zéro toutes les $2^6$ impulsions, est reliée par une porte inverseuse 19 à l'entrée d'un compteur 5a relié en cascade avec un compteur 5b. L'entrée de «remise à zéro» de ces compteurs est également connectée à la porte 16.

Les entrées $D_0$ à $D_5$ de la mémoire 6 sont connectées aux sorties des compteurs 4a et 4b. Cette mémoire qui est initialisée par le signal arrivant en 15, mémorise le reste de la division de P par $2^6$. De leur côté, les entrées $D_0$ à $D_7$ de la mémoire 7 sont connectées aux sorties des compteurs 5a et 5b. Cette mémoire qui est initialisée par le signal arrivant en 15, mémorise donc le quotient de la division de P par $2^6$.

Les sorties $Q_0$ à $Q_5$ de la mémoire 6 sont connectées aux entrées A, B. . . F du dispositif multiplicateur 8 qui est à 6 bits et dont l'entrée d'ordre de chargement est connectée à la porte 16. La sortie inversée S du circuit 8 est connectée à l'une des entrées de la porte 9 dont la sortie est connectée à l'entrée de commande du diviseur programmable. Celui-ci est constitué par deux décompteurs 10a et 10b montés en cascade et dont les entrées $\overline{P_0}$. . .$\overline{P_3}$ sont connectées aux sorties $Q_0$ à $Q_7$ de la mémoire 7. La sortie inversée S de retenue ou de transfert du décompteur 10b est connectée par une porte inverseuse 20 à l'une des entrées d'une porte NON – ou 21 dont l'autre entrée est connectée à la porte 16. La sortie de la porte 21 est connectée à l'entrée inversée d'ordre de chargement des décompteurs 10a et 10b. Elle est également connectée à l'entrée inversée de «remise à zéro» d'une bascule de remise en forme 22 dont l'entrée horloge est connectée à l'horloge générale inversée et l'entrée «données» maintenue à 1. La sortie de la bascule est connectée à l'entrée de commande du dispositif 8.

On voit ainsi que les décompteurs 10a et 10b sont chargés du contenu de la mémoire 7, quotient de la division par $2^6$ d'une part lorsque l'ordre leur est donné par la porte 16 et d'autre part chaque fois qu'il est compté un nombre d'impulsions égal au contenu de la mémoire 7. Par ailleurs, un ordre de commande est envoyé en même temps au dispositif 8, chargé d'un nombre égal au quotient de la division, qui décompte d'une unité et envoie une impulsion négative à la porte 9 en diminuant ainsi d'une unité le nombre d'impulsions transmis par cette porte.

La sortie S du décompteur 10b est en outre connectée à deux compteurs 11a et 11b montés en cascade, dont les entrées de «remise à zéro» sont connectées à la porte 16 et à la sortie desquels on dispose du nombre N recherché.

A la fin d'un créneau, la porte 13 envoie aux mémoires 6 et 7 une impulsion qui assure le chargement dans ces mémoires des contenus des compteurs 4a–4b et 5a–5b. Puis, deux impulsions d'horloge après, la porte 16 envoie une impulsion qui remet à zéro les compteurs 4a–4b, 5a–5b et 11a–11b, et assure le chargement dans le dispositif 8 du contenu de la mémoire 6 ainsi que le chargement dans les décompteurs 10a et 10b du contenu de la mémoire 7.

Lors du créneau suivant, les impulsions que la porte 1 laisse passer pendant ce créneau sont divisées par $2^6$ (dans l'exemple représenté) par les compteurs 4a et 4b. Le quotient de la division est compté par les compteurs 5a et 5b. En même temps, les impulsions sont divisées à l'aide des décompteurs 10a et 10b par le quotient de la division par $2^6$ effectuée lors du passage du créneau prédédent, après suppression d'un nombre d'impulsions par le dispositif 8.

Si l'on reprend l'exemple numérique précédent, le nombre N deviendra. égal à 65 si le nombre d'impulsions correspondant au créneau suivant devient égal à 710, pour reprendre la valeur 64 à la mesure du créneau suivant, le quotient étant alors devenu égal à 11. En période de vitesse stabilisée ou pratiquement stabilisée, le nombre N à ainsi la valeur $N_0$ égale à 64. Mais lors d'une accélération ou d'une décélération importante, le rapport $N/N_0$ indique la valeur de cette accélération ou de cette décélération, ce rapport étant supérieur à 1 dans le premier cas et inférieur à 1 dans le second.

## Revendications

1. Dispositif pour comparer la durée de deux créneaux, comprenant des moyens (4) pour diviser la curée d'un créneau par un nombre $N_0$ donné, des moyens (5–7) pour mettre en mémoire le quotient de la division, et des moyens (10) pour diviser la durée du créneau suivant par ce quotient, caractérisé en ce qu'il comporte en outre des moyens (6) pour mettre en mémoire le reste de la division de la durée d'un créneau par le nombre $N_0$, et des moyens (8–9) pour supprimer de la durée du créneau suivant une fraction de cette durée proportionnelle au reste ainsi mis en mémoire, la durée obtenue par la suppression étant utilisée comme dividende par lesdits moyens (10) pour diviser la durée du créneau suivant.

2. Dispositif selon la revendication 1, caractérisé en ce que les moyens pour supprimer de la durée du créneau suivant une fraction de cette durée comprennent un multiplicateur binaire synchrone à n bits ou B.R.M.

## Patentansprüche

1. Anordnung zum Pulslängenvergleich zweier Rechteckimpulse mit Mitteln (4) zum Dividieren der Pulslänge eines Rechteckimpulses durch eine vorgegebene Zahl $N_0$, Mitteln (5–7) zum Einspeichern des Quotienten der Division und Mitteln (10) zum Dividieren der Pulslänge des folgenden Rechteckimpulses durch diesen Quotienten, dadurch gekennzeichnet, dass sie ausserdem Mittel (6) aufweist zum Einspeichern des Restes der Division der Pulslänge eines Rechteckimpulses durch die Zahl·($N_0$) sowie Mittel (8–9) zum Unterdrücken eines Bruchteils der Pulslänge des folgenden Rechteckimpulses, wobei dieser Bruchteil proportional dem derart eingespeicherten Rest ist und die durch die Unterdrückung erhaltene Puls-länge als Dividend für besagte Mittel (10) zum Dividieren der Pulslänge des folgenden Rechteckimpulses benutzt wird.

2. Anordnung nach Anspruch 1, dadurch gekennzeichnet, dass die Mittel zum Unterdrücken eines Bruchteils der Pulslänge des folgenden Rechteckimpulses einen auf $n$ bits synchronisierten binären Multiplizierer oder einen B.R.M. aufweisen.

## Claims

1. A device to compare the duration of two strobes comprising means to divide the duration of a strobe by a given number $N_0$, means to read-in the quotient of the division, and means to divide the duration of the next strobe by this quotient, wherein it comprises in addition means to read-in the remainder of the division of the duration of a strobe by the number $N_0$, and means (8–9) to suppress from the duration of the next strobe one fraction of this duration proportional to the remainder thus read-in, the duration obtained by the suppression being used as a dividend by sais means so as to divide the duration of the next strobe.

2. Device as claimed in claim 1, wherein the means to suppress from the duration of the strobe one fraction of this duration comprise a synchronous binary multiplier with $n$ bits or a B.R.M.

EP 0 192 530 B1

## FIG. 1

FIG. 2

EP 0 192 530 B1

2/2